# EUROPÄISCHE PATENTSCHRIFT

(11) **EP 3 552 463 B1**
(45) Veröffentlichungstag und Bekanntmachung des Hinweises auf die Patenterteilung: **26.07.2023**
(21) Anmeldenummer: 17816673.2
(22) Anmeldetag: 08.12.2017
(51) Int. Cl.: H05K 1/14, H05K 3/36, H05K 3/28

(54) **LEITERPLATTENVERBUND UND VERFAHREN ZU DESSEN HERSTELLUNG**
PRINTED CIRCUIT BOARD COMPOSITE AND METHOD FOR PRODUCING SAME
ASSEMBLAGE DE CARTES DE CIRCUITS IMPRIMÉS ET SON PROCÉDÉ DE FABRICATION

(30) Priorität: 12.12.2016 DE 102016224653
(43) Veröffentlichungstag der Anmeldung: 16.10.2019
(73) Patentinhaber: Vitesco Technologies Germany GmbH, 93055 Regensburg (DE)
(72) Erfinder: RIETSCH, Jürgen, 90530 Wendelstein (DE); PLACH, Andreas, 91301 Forchheim (DE); ALBERT, Andreas, 91315 Höchstadt/Aisch (DE); STRECKER, Mathias, 74564 Crailsheim (DE); BEL HAJ SAID, Hassene, 90409 Nürnberg (DE); BOCK, Johannes, 91217 Hersbruck (DE); GREIFENSTEIN, Thengis, 90489 Nürnberg (DE)
(74) Vertreter: Vitesco Technologies
(86) Internationale Anmeldenummer: PCT/EP2017/082109
(87) Internationale Veröffentlichungsnummer: WO 2018/108758

(56) Entgegenhaltungen:
- DE-A1- 4 244 626
- DE-A1-102012 213 304
- US-A- 4 513 064
- US-A1- 2013 003 331

## Beschreibung

Die Erfindung betrifft einen Leiterplattenverbund und ein Verfahren zu dessen Herstellung.

Aus dem Stand der Technik sind Leiterplatten allgemein bekannt.

US 4 513 064 A, DE 10 2012 213304 A1, US 2013/003331 A1 und DE 42 44 626 A1 offenbaren Leiterplattenverbunde nach dem Stand der Technik.

Der Erfindung liegt die Aufgabe zugrunde, ein gegenüber dem Stand der Technik verbessertes Verfahren zur Herstellung eines Leiterplattenverbundes und einen gegenüber dem Stand der Technik verbesserten Leiterplattenverbund anzugeben.

Die Aufgabe wird erfindungsgemäß gelöst durch ein Verfahren zur Herstellung eines Leiterplattenverbundes mit den Merkmalen des Anspruchs 1 und einen Leiterplattenverbund mit den Merkmalen des Anspruchs 6.

Vorteilhafte Ausgestaltungen der Erfindung sind Gegenstand der Unteransprüche.

In einem erfindungsgemäßen Verfahren zur Herstellung eines Leiterplattenverbundes wird eine erste Leiterplatte, insbesondere eine Sensorträgerleiterplatte, mit einer zweiten Leiterplatte, insbesondere einer Stützleiterplatte, formschlüssig verbunden. Dadurch wird ein Stützen der ersten Leiterplatte durch die zweite Leiterplatte insbesondere während eines Verbindungsprozesses der ersten Leiterplatte und der zweiten Leiterplatte mit einer insbesondere als Hauptleiterplatte ausgebildeten dritten Leiterplatte erreicht. Dieser Verbindungsprozess umfasst beispielsweise das Anordnen der ersten und zweiten Leiterplatte auf der dritten Leiterplatte und das bereichsweise oder vollständige Umspritzen zumindest der ersten Leiterplatte mit einem Kunststoff, insbesondere mit einem Duroplastkunsstoff, in einem Kunststoffumspritzprozess, in welchem zumindest die erste und zweckmäßigerweise auch die zweite Leiterplatte in einem Kunststoffspritzwerkzeug angeordnet und mit Kunststoff umspritzt werden.

Erfindungsgemäß weisen beide Leiterplatten jeweils eine Nut auf, wobei die beiden Leiterplatten derart miteinander verbunden werden, dass sich Nutböden der beiden Nuten berühren. Die beiden Leiterplatten werden somit derart zusammengefügt, dass sich deren Nuten ineinanderschieben, so dass Nutseitenwände der ersten Leiterplatte an Flachseiten der zweiten Leiterplatte anliegen und Nutseitenwände der zweiten Leiterplatte an Flachseiten der ersten Leiterplatte anliegen. Diese Verbindung wird auch als Zweinutverbindung bezeichnet. Zweckmäßigerweise wird dadurch ein Verklemmen der jeweiligen Leiterplatte in der Nut der jeweiligen anderen Leiterplatte erreicht, so dass nicht nur eine formschlüssige, sondern auch eine kraftschlüssige Verbindung erreicht wird.

Erfindungsgemäß werden die beiden Leiterplatten derart zueinander ausgerichtet verbunden, dass Flächennormalen der beiden Leiterplatten rechtwinklig zueinander ausgerichtet sind.

Erfindungsgemäß verlaufen Längenausdehnungen der beiden Leiterplatten dabei parallel zueinander. Zweckmäßigerweise sind die Längenausdehnungen der beiden Leiterplatten im Wesentlichen gleich groß und die beiden Leiterplatten liegen im Wesentlichen über ihren Längenausdehnungsbereich aneinander an oder die zweite Leiterplatte liegt über einen wesentlichen Längenausdehnungsbereich der ersten Leiterplatte, insbesondere über mehr als die Hälfte des Längenausdehnungsbereichs der ersten Leiterplatte, an der ersten Leiterplatte an. Zweckmäßigerweise sind die erste und zweite Leiterplatte derart ausgebildet und werden derart miteinander verbunden, dass die erste Leiterplatte über ihren gesamten Längenausdehnungsbereich oder über einen wesentlichen Teil davon, insbesondere über mehr als die Hälfte des Längenausdehnungsbereichs, von der zweiten Leiterplatte gestützt wird.

Erfindungsgemäß werden die beiden Leiterplatten derart miteinander verbunden, dass ein auf der ersten Leiterplatte angeordnetes Bauelement, insbesondere ein Sensor, durch die zweite Leiterplatte in seiner Position gestützt wird. Hierzu liegt die zweite Leiterplatte nach dem Verbinden der beiden Leiterplatten zweckmäßigerweise am Bauelement an, insbesondere an zumindest einer Umfangsseite des Bauelements oder an mehreren Umfangsseiten. Beispielsweise wird die zweite Leiterplatte am Sensor verrastet. Auf diese Weise wird das Bauelement auf der ersten Leiterplatte durch die zweite Leiterplatte gestützt und in Position gehalten, zum Beispiel während des Kunststoffumspritzprozesses. Durch eine entsprechende Formgebung der zweiten Leiterplatte ist eine Stützung für verschiedene Bauelementaufbaukonzepte, beispielsweise Sensoraufbaukonzepte, möglich. Durch diese Stützung des Bauelements, beispielsweise des Sensors, wird insbesondere eine verbesserte Positioniergenauigkeit erreicht.

Vorteilhafterweise kann vorgesehen sein, dass die beiden Leiterplatten miteinander verrastet werden. Beispielsweise weisen die beiden Leiterplatten korrespondierende Rasthaken oder andere korrespondierende Rastelemente auf. Beispielsweise weist eine der Leiterplatten eine oder mehrere Rastnasen und die andere Leiterplatte eine zur jeweiligen Rastnase korrespondierende Rastöffnung auf. Dadurch wird ein Auseinanderdriften der beiden Leiterplatten, insbesondere während des Kunststoffumspritzprozesses, vermieden.

Zweckmäßigerweise wird zumindest die erste Leiterplatte mit der dritten Leiterplatte, insbesondere der Hauptleiterplatte, verbunden. Dadurch wird beispielsweise ein so genannter Sensordom ausgebildet, wenn das Bauelement auf der ersten Leiterplatte als ein Sensor ausgebildet ist. Dabei steht die erste Leiterplatte zweckmäßigerweise senkrecht auf der dritten Leiterplatte.

In einer vorteilhaften Ausführungsform wird zumindest eine Positionierausformung der ersten Leiterplatte in eine korrespondierende Ausnehmung in der dritten Leiterplatte eingeführt. Dadurch wird eine Position der ersten Leiterplatte relativ zur dritten Leiterplatte, insbesondere relativ zu Lötstellen auf der dritten Leiterplatte, gesichert.

Es kann vorgesehen sein, dass die erste Leiterplatte und die dritte Leiterplatte miteinander verlötet werden. Beispielsweise ist hierzu die zumindest eine Positionierausformung zumindest bereichsweise, zweckmäßigerweise umlaufend, metallisch beschichtet. Zweckmäßigerweise erfolgt das Verlöten ohne elektrische Kontaktführung, d. h. über diese Verlötung ist später keine Stromführung vorgesehen. Dies wird auch als Prinzip der Blindkontaktverlötung bezeichnet.

Zweckmäßigerweise wird zumindest die erste Leiterplatte mit einem Kunststoff, insbesondere mit einem Duroplastkunststoff, zumindest bereichsweise umspritzt. Vorzugsweise werden auch die zweite Leiterplatte zumindest bereichsweise und/oder zumindest ein Bereich der dritten Leiterplatte mit dem Kunststoff umspritzt. Dadurch wird eine stoffschlüssige Verbindung der ersten Leiterplatte mit der zweiten und/oder dritten Leiterplatte erreicht.

Im Folgenden werden nochmals vorteilhafte Ausführungsformen des Verfahrens zur Herstellung des Leiterplattenverbundes beschrieben. Der mittels des beschriebenen Verfahrens hergestellte Leiterplattenverbund kann beispielsweise in einem Fahrzeug verwendet werden, beispielsweise in einem Getriebesteuergerät. Dabei ist die erste Leiterplatte zweckmäßigerweise als Sensorträgerleiterplatte ausgebildet, welche als Bauelement den Sensor trägt, und die dritte Leiterplatte ist als Hauptleiterplatte ausgebildet. Ein Fügeprozess zum Verbinden der ersten und zweiten Leiterplatte erfolgt zweckmäßigerweise, wie bereits beschrieben, über die so genannte Zweinutsteckung. Die als Stützleiterplatte ausgebildete zweite Leiterplatte hat die Funktion, die zweckmäßigerweise als Sensorträgerleiterplatte ausgebildete erste Leiterplatte in einem nachfolgenden Montageprozess, Lötprozess und/oder Kunststoffumspritzprozess, insbesondere Duroplastumspritzprozess, zu stützen.

Die mit einem oder mehreren beispielsweise jeweils als Sensor ausgebildeten Bauelementen bestückte und zweckmäßigerweise als Sensorträgerleiterplatte ausgebildete erste Leiterplatte wird zweckmäßigerweise bezüglich der dritten Leiterplatte in Position gehalten über eine oder mehrere Positionierausformungen, auch als Positionierpins bezeichnet. Sie wird zweckmäßigerweise im Bereich von Lötstellen in der dritten Leiterplatte in Position gehalten. Die Positionierung kann erfolgen durch Klemmung in entsprechenden Ausnehmungen, beispielsweise Aufnahmebohrungen in der dritten Leiterplatte. In anderen Ausführungsformen können an der dritten Leiterplatte eine oder mehrere Positionierausformungen und in der ersten Leiterplatte eine jeweilige korrespondierende Ausnehmung vorgesehen sein.

Des Weiteren kann die jeweilige Positionierausformung umlaufend metallisch beschichtet sein und ohne elektrische Kontaktführung eingelötet werden (Prinzip der Blindkontaktverlötung). Zweckmäßigerweise wird die erste Leiterplatte, insbesondere Sensorträgerleiterplatte, vorzugsweise nach dem Bestücken, in einem Kunststoffumspritzungsprozess, insbesondere Duroplastumspritzungsprozess in einem entsprechenden Werkzeug aufgenommen und in x-Richtung und y-Richtung, d. h. in Breitenausdehnungsrichtung und Dickenausdehnungsrichtung aufgenommen. Die Z- Richtung, d. h. die Längenausdehnungsrichtung, bleibt frei, um keine Druckkräfte auf die beispielsweise als Hauptleiterplatte ausgebildete dritte Leiterplatte und die Lötstellen zu erhalten.

Durch eine weitere Formgebung der als Stützleiterplatte ausgebildeten zweiten Leiterplatte kann das Bauelement, beispielsweise der Sensor, auf der ersten Leiterplatte gestützt werden, um eine verbesserte Positioniergenauigkeit des Bauelements, insbesondere des Sensors, zu erhalten. Hier ist eine Unterstützung für unterschiedliche Bauelementaufbaukonzepte, insbesondere Sensoraufbaukonzepte, möglich. Auch kann das Bauelement, insbesondere der Sensor, durch eine Ausnehmung in der als Stützleiterplatte ausgebildeten zweiten Leiterplatte von oben und unten genauer in Position gehalten werden im Kunststoffumspritzungsprozess.

Um ein Auseinanderdriften der ersten und zweiten Leiterplatte insbesondere im oberen Bereich zu vermeiden, können Verrastungen, beispielsweise Rasthaken, vorgesehen sein, die im Zusammenfügungsprozess der ersten und zweiten Leiterplatte ineinander eingeschoben werden und somit noch mehr Stabilität beispielsweise im oben bereits erwähnten Sensordomkonzept ermöglichen.

Nach dem Zusammenfügen der drei Leiterplatten kann das Sensordomkonzept mit Kunststoff, insbesondere Duroplast, umspritzt werden. Dabei wird insbesondere die erste Leiterplatte zumindest bereichsweise umspritzt. Durch abgestimmte Supportgeometrien kann die Position insbesondere der ersten Leiterplatte mit dem Bauelement im Umspritzungswerkzeug während des Umspritzungsvorganges genauer gehalten werden.

Ein erfindungsgemäßer Leiterplattenverbund, welcher insbesondere mittels des oben beschriebenen Verfahrens hergestellt ist, umfasst mindestens zwei formschlüssig miteinander verbundene Leiterplatten. Dabei wird durch die zweite Leiterplatte die Stützung der ersten Leiterplatte erreicht, insbesondere für nachfolgende Bearbeitungsprozesse und/oder einen Einsatz des Leiterplattenverbundes in einem Gerät, beispielsweise in einem Steuergerät eines Fahrzeugs, zum Beispiel in einem Getriebesteuergerät.

Zweckmäßigerweise umfasst der Leiterplattenverbund drei miteinander verbundene Leiterplatten, vorzugsweise die als Sensorträgerleiterplatte ausgebildete erste Leiterplatte, zu deren Stützung die als Stützleiterplatte ausgebildete zweite Leiterplatte und die als Hauptleiterplatte ausgebildete dritte Leiterplatte.

Die erste und zweite Leiterplatte sind formschlüssig miteinander verbunden, insbesondere über die Zweinutsteckung, und können zudem kraftschlüssig und/oder stoffschlüssig verbunden sein, stoffschlüssig beispielsweise durch das Kunststoffumspritzen.

Die dritte Leiterplatte ist mit der ersten und/oder zweiten Leiterplatte formschlüssig, kraftschlüssig und/oder stoffschlüssig verbunden, beispielsweise verlötet, durch das Kunststoffumspritzen und/oder durch das Einfügen und beispielsweise verklemmen einer oder mehrerer Positionierausformungen in einer jeweiligen korrespondierenden Ausnehmung. Die erste Leiterplatte ist im Wesentlichen senkrecht zur dritten Leiterplatte ausgerichtet. Dadurch wird, wenn das Bauelement auf der ersten Leiterplatte als ein Sensor ausgebildet ist, ein Sensordom erreicht, mittels welchem der Sensor von der zweckmäßigerweise als Hauptleiterplatte ausgebildeten dritten Leiterplatte beabstandet ist.

Ausführungsbeispiele der Erfindung werden im Folgenden anhand von Zeichnungen näher erläutert.

Dabei zeigen:
- Figur 1: schematisch eine perspektivische Darstellung einer Ausführungsform eines Leiterplattenverbundes aus zwei Leiterplatten,
- Figur 2: schematisch eine weitere perspektivische Darstellung der Ausführungsform des Leiterplattenverbundes aus Figur 1,
- Figur 3: schematisch eine Montage des Leiterplattenverbundes aus den Figuren 1 und 2,
- Figur 4: schematisch eine perspektivische Darstellung eines Leiterplattenverbundes aus drei Leiterplatten,
- Figur 5: schematisch eine perspektivische Darstellung einer Ausführungsform eines Leiterplattenverbundes aus zwei Leiterplatten außerhalb des Schutzumfangs der Ansprüche,
- Figur 6: schematisch eine perspektivische Darstellung einer weiteren Ausführungsform eines Leiterplattenverbundes aus zwei Leiterplatten, und
- Figur 7: schematisch eine weitere perspektivische Darstellung der Ausführungsform des Leiterplattenverbundes aus Figur 6.

Einander entsprechende Teile sind in allen Figuren mit den gleichen Bezugszeichen versehen.

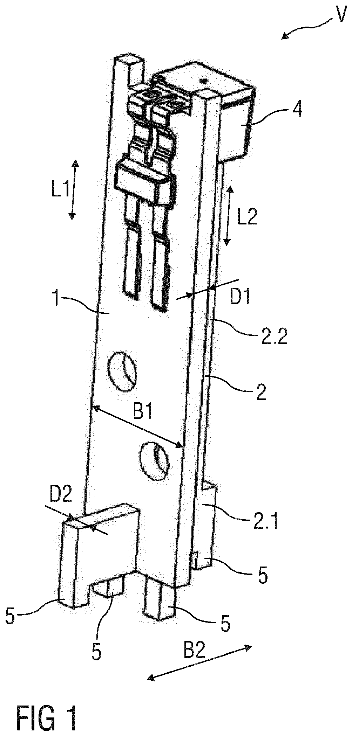

Die Figuren 1 und 2 sowie 5 bis 7 zeigen schematische Darstellungen eines Leiterplattenverbundes V aus zwei zumindest formschlüssig miteinander verbundenen Leiterplatten 1, 2. Dabei trägt die erste Leiterplatte 1 zumindest ein Bauelement 4, insbesondere ein elektronisches Bauelement 4. Im dargestellten Beispiel ist dieses Bauelement 4 als ein Sensor ausgebildet, so dass diese erste Leiterplatte 1 als eine Sensorträgerleiterplatte ausgebildet ist.

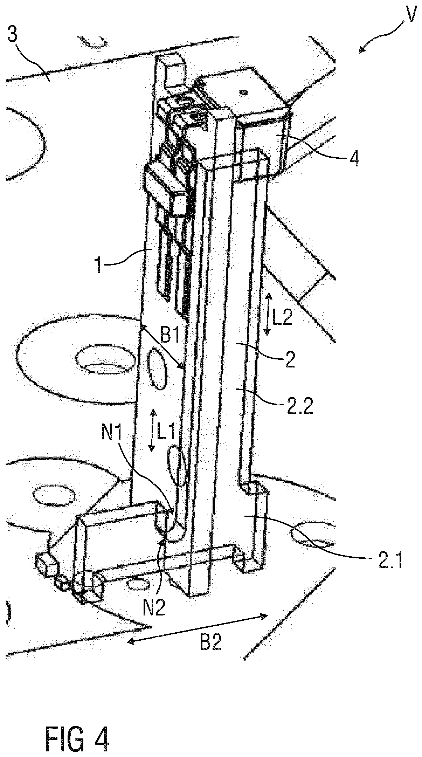

Die zweite Leiterplatte 2 ist als eine Stützleiterplatte ausgebildet, deren Funktion es ist, die erste Leiterplatte 1 zu stützen, insbesondere während eines im Folgenden beschriebenen Verbindungsprozesses zum Verbinden zumindest der ersten Leiterplatte 1 mit einer in Figur 4 dargestellten dritten Leiterplatte 3, beispielsweise einer Hauptleiterplatte, zum Leiterplattenverbund V, welcher dann diese drei Leiterplatten 1, 2, 3 umfasst. Dieser Verbindungsprozess, während dessen die zweite Leiterplatte 2 die erste Leiterplatte 1 stützt, so dass insbesondere sichergestellt wird, dass die erste Leiterplatte 1 ihre Position relativ zur dritten Leiterplatte 3 nicht verändert, umfasst beispielsweise einen Montageprozess, einen Lötprozess und/oder einen Kunststoffumspritzprozess, insbesondere mit einem duroplastischen Kunststoff.

Zusätzlich zu dieser Stützfunktion kann beispielsweise auch die zweite Leiterplatte 2 ein oder mehrere Bauelemente 4, insbesondere elektronische Bauelemente 4, und/oder elektrische Leiterzüge tragen, ebenso wie die erste Leiterplatte 1.

Der Leiterplattenverbund V kann beispielsweise in einem Fahrzeug verwendet werden, zum Beispiel in einem Steuergerät des Fahrzeugs, beispielsweise in einem Getriebesteuergerät. Es sind jedoch auch andere Einsatzmöglichkeiten denkbar, insbesondere in elektrischen oder elektronischen Geräten, welche mehrere miteinander verbundene Leiterplatten aufweisen.

In einem Verfahren zur Herstellung des Leiterplattenverbundes V, welcher zumindest die erste Leiterplatte 1 und die zweite Leiterplatte 2 umfasst und zweckmäßigerweise des Weiteren, wie in Figur 4 gezeigt, auch die dritte Leiterplatte 3 umfasst, werden die erste Leiterplatte 1 und die zweite Leiterplatte 2 zumindest formschlüssig miteinander verbunden. Dies erfolgt vorteilhafterweise über eine so genannte Zweinutsteckung.

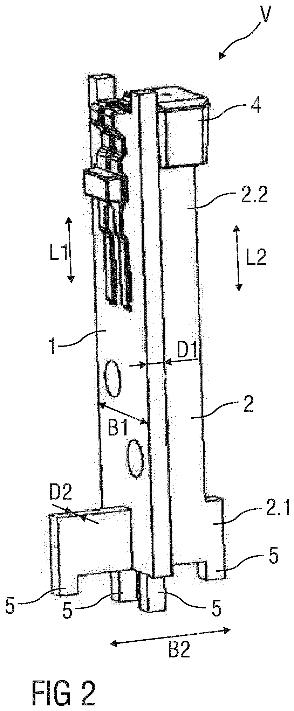

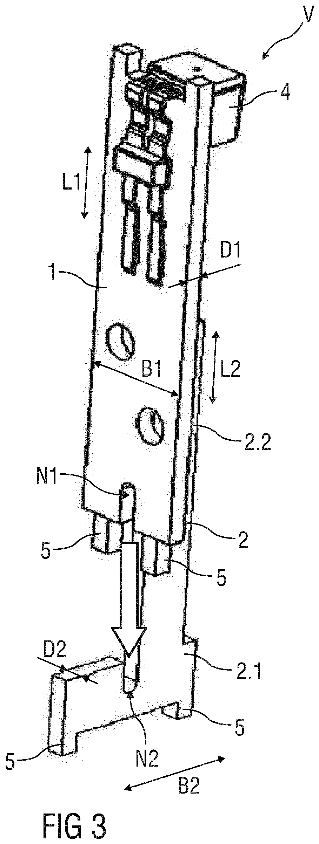

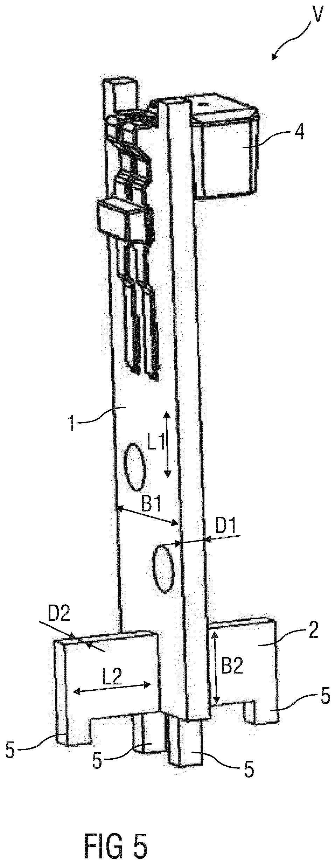

Um dies zu ermöglichen, weisen die erste Leiterplatte 1 und die zweite Leiterplatte 2 jeweils zumindest eine Nut N1, N2 auf. Die erste Leiterplatte 1 und die zweite Leiterplatte 2 werden, wie in Figur 3 gezeigt, derart miteinander verbunden, dass sich Nutböden der beiden Nuten N1, N2 berühren. Das Verbinden der ersten Leiterplatte 1 und zweiten Leiterplatte 2 ist in Figur 3 am Beispiel der in den Figuren 1 und 2 dargestellten ersten Leiterplatte 1 und zweiten Leiterplatte 2 gezeigt. Das Verbinden der in den Figuren 5 bis 7 dargestellten Ausführungsformen der ersten und zweiten Leiterplatte 1, 2 erfolgt im Wesentlichen auf die gleiche Weise.

Die erste Leiterplatte 1 und die zweite Leiterplatte 2 sind plattenförmig ausgebildet und weisen daher jeweils zwei gegenüberliegende Flachseiten, zwei Längsseiten und zwei Querseiten auf. Die Längsseiten und Querseiten bilden im Wesentlichen einen umlaufenden Seitenrand der jeweiligen Leiterplatte 1, 2. Die erste Leiterplatte 1 und die zweite Leiterplatte 2 sind im Wesentlichen länglich ausgebildet, d. h. sie weisen jeweils eine Längenausdehnung L1, L2, eine Breitenausdehnung B1, B2 und eine Dickenausdehnung D1, D2 auf, wobei die Längenausdehnung L1, L2 größer ist, insbesondere wesentlich größer ist, als die Breitenausdehnung B1, B2 und wobei die Breitenausdehnung B1, B2 größer ist, insbesondere wesentlich größer ist, als die Dickenausdehnung D1, D2. Entsprechend der Längsausdehnung L1, L2 und Breitenausdehnung B1, B2 sind die Längsseiten länger als die Querseiten der jeweiligen Leiterplatte 1, 2. Unter Längenausdehnung L1, L2 ist eine Ausdehnung der jeweiligen Leiterplatte 1, 2 in ihrer Längsrichtung zu verstehen. Unter Breitenausdehnung B1, B2 ist eine Ausdehnung der jeweiligen Leiterplatte 1, 2 in ihrer Querrichtung, d. h. Breitenrichtung, zu verstehen. Unter Dickenausdehnung D1, D2 ist eine Ausdehnung der jeweiligen Leiterplatte 1, 2 in ihrer Dickenrichtung zu verstehen.

Die jeweilige Nut N1, N2 ist als eine Vertiefung im jeweiligen Seitenrand ausgebildet. Eine Nuttiefenrichtung verläuft somit von einem oberen Nutrand, d. h. von einer Nutöffnung, zum Nutboden der jeweiligen Nut N1, N2. Eine Nutverlaufsrichtung der jeweiligen Nut N1, N2 verläuft rechtwinklig zur Nuttiefenrichtung und somit von einer Flachseite zur gegenüberliegenden Flachseite der jeweiligen Leiterplatte 1, 2.

Die Nut N1 in der ersten Leiterplatte 1 ist im Bereich einer der Querseiten ausgebildet, wobei sich die Nuttiefenrichtung in Richtung der anderen Querseite erstreckt, d. h. in Richtung der Längenausdehnung L1 der ersten Leiterplatte 1. Insbesondere ist die Nut N1 im Bereich der vom auf der ersten Leiterplatte 1 angeordneten Bauelement 4 abgewandten Querseite ausgebildet. Diese Querseite, in welcher die Nut N1 ausgebildet ist, ist zur Verbindung mit der dritten Leiterplatte 3 vorgesehen. Sie weist daher in den dargestellten Ausführungsbeispielen gemäß den Figuren 1 bis 7 beidseits der Nut N1 jeweils eine Positionierausformung 5, auch als Positionierpins bezeichnet, in Längenausdehnung L1 der ersten Leiterplatte 1 auf, welche zur Montage der ersten Leiterplatte 1 mit der dritten Leiterplatte 3 in eine jeweilige korrespondierende Ausnehmung, beispielsweise eine Aufnahmebohrung, in der dritten Leiterplatte 3 eingeführt wird.

Die zweite Leiterplatte 2 weist in den Ausführungsbeispielen gemäß den Figuren 1 bis 4 sowie 6 und 7 einen breiten Bereich 2.1 und einen anschließenden schmalen Bereich 2.2 auf, wobei eine Breitenausdehnung B2 des breiten Bereichs 2.1 größer ist als eine Breitenausdehnung B2 des schmalen Bereichs 2.2. Der breite Bereich 2.1 erstreckt sich bis zu einer Querseite der zweiten Leiterplatte 2, welche zur Verbindung mit der dritten Leiterplatte 3 vorgesehen ist. Sie weist daher zweckmäßigerweise ebenfalls zwei Positionierausformungen 5, auch als Positionierpins bezeichnet, in Längenausdehnung L2 der zweiten Leiterplatte 2 auf, welche zur Montage der zweiten Leiterplatte 2 mit der dritten Leiterplatte 3 in eine jeweilige korrespondierende Ausnehmung, beispielsweise Aufnahmebohrung, in der dritten Leiterplatte 3 eingeführt werden. Alternativ können anstelle der Positionierausformungen 5 Stützfüße vorgesehen sein, welche auf eine Flachseite der dritten Leiterplatte 3 aufsetzen.

Die Nut N2 ist in der zweiten Leiterplatte 2 in einer Randseite des breiten Bereichs 2.1 ausgebildet, welche der dem schmalen Bereich 2.2 zugeordneten Querseite der zweiten Leiterplatte 2 zugewandt ist. Die Nuttiefenrichtung verläuft dabei in Richtung der Längenausdehnung L2 der zweiten Leiterplatte 2, wobei der Nutboden näher an der dem breiten Bereich 2.1 zugeordneten Querseite und der Nutrand demzufolge näher an der dem schmalen Bereich 2.2 zugeordneten Querseite angeordnet ist. Eine der Nutwände ist dabei als eine Verlängerung eines Längsrandbereichs des schmalen Bereichs 2.2 in den breiten Bereich 2.1 hinein ausgebildet.

Werden die erste Leiterplatte 1 und die zweite Leiterplatte 2 auf die in Figur 3 gezeigte Weise über die Zweinutsteckung miteinander verbunden, liegen Nutseitenwände der Nut N1 in der ersten Leiterplatte 1 an jeweils einer Flachseite der zweiten Leiterplatte 2 an und Nutseitenwände der Nut N2 in der zweiten Leiterplatte 2 liegen an jeweils einer Flachseite der ersten Leiterplatte 1 an, so dass die Leiterplatten 1, 2 über die Nuten N1, N2 zweckmäßigerweise miteinander verklemmt sind. Zudem liegt der schmale Bereich 2.2 der zweiten Leiterplatte 2 über einen wesentlichen Teil der Längenausdehnung L1 der ersten Leiterplatte 1, insbesondere über mehr als die Hälfte der Längenausdehnung L1 der ersten Leiterplatte 1, an der einen Flachseite der ersten Leiterplatte 1 an und stützt somit die erste Leiterplatte 1 insbesondere gegen ein Verkippen ab.

Die erste Leiterplatte 1 und die zweite Leiterplatte 1 werden somit derart miteinander verbunden oder sind im fertiggestellten Leiterplattenverbund V derart miteinander verbunden, dass Flachseiten der ersten Leiterplatte 1 rechtwinklig zu Flachseiten der zweiten Leiterplatte 2 ausgerichtet sind, d. h. Flächennormalen der ersten und zweiten Leiterplatte 1, 2 sind rechtwinklig zueinander ausgerichtet. Dabei sind die Längenausdehnungen L1, L2, insbesondere deren jeweilige Richtung, der beiden Leiterplatten 1, 2 parallel zueinander ausgerichtet. Die Nutverlaufsrichtungen der beiden Nuten N1, N2 sind dabei rechtwinklig zueinander ausgerichtet und die Nuttiefenrichtungen der beiden Nuten N1, N2 sind parallel zueinander ausgerichtet.

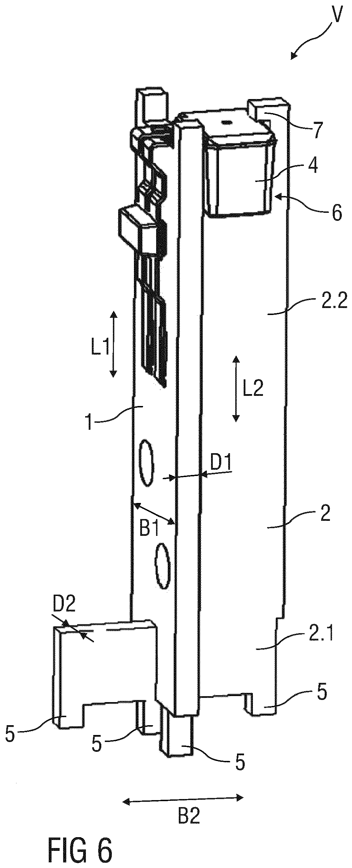

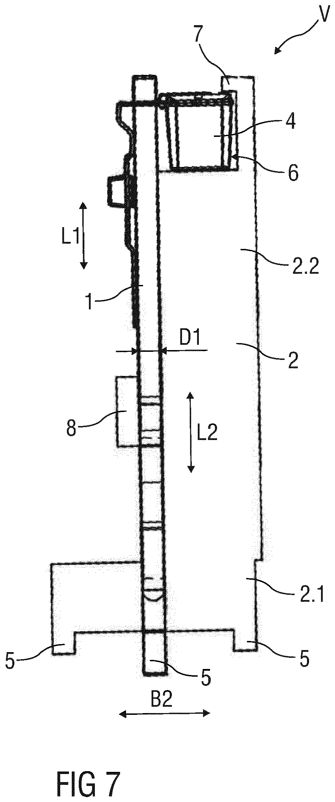

Durch eine entsprechende Ausformung der zweiten Leiterplatte 2 wird es zudem ermöglicht, dass zumindest eine Bauelement 4, insbesondere den Sensor, auf der ersten Leiterplatte 1 durch die zweite Leiterplatte 2 zu stützen, um dadurch eine verbesserte Positioniergenauigkeit dieses Bauelements 4 zu erhalten. In den Ausführungsbeispielen gemäß den Figuren 1 bis 4 wird dies dadurch erreicht, dass die Längenausdehnung L2 der zweiten Leiterplatte 2 derart ausgebildet ist, dass sich die zweite Leiterplatte 2 im mit der ersten Leiterplatte 1 zusammengefügten Zustand bis an das zu stützende Bauelement 4 auf der ersten Leiterplatte 1 heran erstreckt, d. h. am zu stützenden Bauelement 4 anliegt. In den Ausführungsbeispielen gemäß den Figuren 6 und 7 wird dies dadurch erreicht, dass die zweite Leiterplatte 2 derart ausgebildet ist, dass sie im mit der ersten Leiterplatte 1 zusammengefügten Zustand das zu stützende Bauelement 4 zumindest bereichsweise umschließt. D. h. die zweite Leiterplatte 2 weist eine mit einer Bauelementform des zu stützenden Bauelements 4 korrespondierende Bauelementausnehmung 6 auf, in welcher das zu stützende Bauelement 4 nach dem Zusammenfügen der ersten und zweiten Leiterplatte 1, 2 angeordnet ist und dadurch in mehrere Richtungen, insbesondere von oben und unten, d. h. in Längenausdehnungsrichtung der ersten Leiterplatte 1, durch die zweite Leiterplatte 2 gestützt ist. Dies ermöglicht insbesondere eine Positionssicherung des Bauelements 4, beispielsweise des Sensors, im Kunststoffumspritzprozess. Beispielsweise weist die zweite Leiterplatte 2 eine Rastnase 7 auf, mit welcher sie am Bauelement 4 einrastet. Auf die beschriebene Weise können mittels der zweiten Leiterplatte 2, bei entsprechender Ausformung der zweiten Leiterplatte 2, auch mehrere Bauelemente 4 auf der ersten Leiterplatte 1 gestützt werden.

Durch eine entsprechend angepasste Formgebung der zweiten Leiterplatte 2 ist eine Stützung für unterschiedlich ausgebildete Bauelemente 4, beispielsweise für unterschiedliche Sensoraufbaukonzepte, möglich. Die Formgebung der zweiten Leiterplatte 2 ist hierzu an die Ausbildung des jeweiligen Bauelements 4 anzupassen.

In einem Ausführungsbeispiel außerhalb des Schutzumfangs der Ansprüche gemäß Figur 5 ist die erste Leiterplatte 1 derart ausgebildet, wie bereits oben zu den Figuren 1 bis 4 sowie 6 und 7 beschrieben. Die zweite Leiterplatte 2 ist jedoch wesentlich kürzer, sie umfasst im Wesentlichen lediglich den breiten Bereich 2.1 der zweiten Leiterplatte 2 gemäß den anderen Ausführungsbeispielen.

Daher ist hier die Nut N2 im Bereich einer Längsseite ausgebildet, wobei sich die Nuttiefenrichtung in Richtung der anderen Längsseite erstreckt, d. h. in Richtung der Breitenausdehnung B2 der zweiten Leiterplatte 2. Die Nut N2 ist dabei im Bereich der Längsseite ausgebildet, welche nicht zur Verbindung mit der dritten Leiterplatte 3 vorgesehen ist. Die andere Längsseite, welche zur Verbindung mit der dritten Leiterplatte 3 ausgebildet ist, weist bei dieser Ausführungsform der zweiten Leiterplatte 2 die beiden Positionierausformungen 5 oder Füße in Breitenausdehnung B2 der zweiten Leiterplatte 2 auf.

Zur Montage des Leiterplattenverbundes V, welcher zweckmäßigerweise die erste, zweite und dritte Leiterplatte 1, 2, 3 umfasst, werden somit vorteilhafterweise die erste und zweite Leiterplatte 1, 2 über die Zweinutsteckung miteinander verbunden, wie in Figur 3 gezeigt, und anschließend werden die erste und zweite Leiterplatte 1, 2 mit der dritten Leiterplatte 3 verbunden, wie in Figur 4 gezeigt. Dabei wird die erste Leiterplatte 1 über ihre Positionierausformungen 5, d. h. die Positionierpins, auf der dritten Leiterplatte 3 in Position gehalten, zweckmäßigerweise im Bereich von Lötstellen auf der dritten Leiterplatte 3. Diese Positionierung erfolgt hier durch Klemmung der Positionierausformungen 5 in der jeweiligen korrespondierenden Ausnehmung in der dritten Leiterplatte 3. Alternativ kann auch zunächst die zweite Leiterplatte 2 auf der dritten Leiterplatte 3 angeordnet werden und danach die erste Leiterplatte 1 auf die beschriebene Weise in die zweite Leiterplatte 2, wenn vorhanden, mit ihrer jeweiligen Positionierungsausformung 5 in die jeweilige korrespondierende Ausnehmung in der dritten Leiterplatte 3 eingeschoben werden.

Dies gilt zweckmäßigerweise auch für die zweite Leiterplatte 2 und deren Positionierausformungen 5, falls diese vorhanden sind. Die Positionierausformungen 5 der ersten und/oder zweiten Leiterplatte 1, 2 können zumindest bereichsweise, vorteilhafterweise umlaufend, metallisch beschichtet sein und, zweckmäßigerweise ohne elektrische Kontaktführung, in die dritte Leiterplatte 3 eingelötet werden. Dies wird als Prinzip der Blindkontaktverlötung bezeichnet. Dieses Verlöten der ersten und/oder zweiten Leiterplatte 1, 2 mit der dritten Leiterplatte 3 dient somit lediglich der Positionssicherung der ersten und/oder zweiten Leiterplatte 1, 2 relativ zur dritten Leiterplatte 3.

Wie in Figur 4 gezeigt, ist nach diesem Zusammenfügen der drei Leiterplatten 1, 2, 3 die erste Leiterplatte 1 senkrecht auf der zweiten Leiterplatte 3 angeordnet, wobei ihre Längenausdehnung L1 parallel zu einem Normalenvektor der dritten Leiterplatte 3, d. h. zum Normalenvektor der Flachseite der dritten Leiterplatte 3, verläuft. Dadurch ist das Bauelement 4, beispielsweise der Sensor, auf der ersten Leiterplatte 1 mittels dieser von der dritten Leiterplatte beabstandet angeordnet.

Zweckmäßigerweise wird die erste Leiterplatte 1 nach dem bestücken, d. h. nach dem Verbinden mit der dritten Leiterplatte 3 auf die oben beschriebene Weise und/oder nach einem Bestücken der ersten und/oder dritten Leiterplatte 1, 3 mit weiteren Bauelementen 4, in einem Kunststoffumspritzwerkzeug, insbesondere in einem Duroplastumspritzwerkzeug, aufgenommen. Sie wird dort zweckmäßigerweise in x-Richtung, d. h. in Dickenausdehnungsrichtung, und in y-Richtung, d. h. in Breitenausdehnungsrichtung, im Kunststoffumspritzwerkzeug gehalten. Die z-Richtung, d. h. die Längenausdehnungsrichtung, bleibt zweckmäßigerweise frei, d. h. in dieser Richtung liegt die erste Leiterplatte 1 nicht an einer Innenseite des Kunststoff- umspritzwerkzeugs an, damit keine Druckkräfte auf die dritte Leiterplatte 3 und auf Lötstellen einwirken.

Zur Vollendung der Herstellung des Leiterplattenverbundes V aus erster, zweiter und dritter Leiterplatte 1, 2, 3 wird nun die erste Leiterplatte 1 mit einem Kunststoff, insbesondere mit einen Duroplastkunststoff, zumindest bereichsweise oder vollständig umspritzt. Zweckmäßigerweise werden dabei auch die zweite Leiterplatte 2 bereichsweise oder vollständig und/oder zumindest Bereiche der dritten Leiterplatte 3 mit dem Kunststoff, insbesondere Duroplast, umspritzt.

Ist das Bauelement 4 auf der ersten Leiterplatte 1 als ein Sensor ausgebildet, wird durch diesen Leiterplattenverbund V ein so genannter Sensordom realisiert. Bei einem Sensordom ist der Sensor von der zweckmäßigerweise als Hauptleiterplatte ausgebildeten dritten Leiterplatte 3 beabstandet angeordnet, so dass er zum Beispiel aus einem Steuergerätgehäuse herausragen kann und in eine andere Einheit, beispielsweise in ein Getriebe eines Fahrzeugs, hineinragt oder zumindest an einem Gehäuse oder in einer Gehäuseausnehmung des Gehäuses der anderen Einheit angeordnet ist.

Um, insbesondere während des Kunststoffumspritzens, ein Auseinanderdriften der ersten und zweiten Leiterplatte 1, 2 insbesondere im von der dritten Leiterplatte 3 abgewandten Bereich zu vermeiden, kann vorgesehen sein, dass die erste Leiterplatte 1 und die zweite Leiterplatte 2 miteinander verrastet werden, wie beispielsweise in Figur 7 gezeigt. Hierzu weisen die erste Leiterplatte 1 und die zweite Leiterplatte 2 zweckmäßigerweise eine oder mehrere korrespondierende Rastausformungen auf. Beispielsweise ist in einer der beiden Leiterplatten 1, 2, in Figur 7 in der ersten Leiterplatte 1, zumindest eine Rastöffnung ausgebildet und an der anderen Leiterplatte 2, 1, in Figur 7 an der zweiten Leiterplatte 2, ist eine korrespondierende Leiterplattenrastnase 8 ausgebildet, welche durch das Zusammenfügen der beiden Leiterplatten 1, 2 in die Rastöffnung einrastet. In anderen Ausführungsformen können korrespondierende Rasthaken an der ersten und zweiten Leiterplatte 1, 2 vorgesehen sein, welche durch das Zusammenfügen der ersten und zweiten Leiterplatte 1, 2 ineinander eingeschoben werden und einrasten. Durch diese Verrastung wird eine größere Stabilität während des Kunststoffumspritzens und beispielsweise auch während eines Einsatzes des Leiterplattenverbundes V erreicht.

Um eine Positionshaltung der Leiterplatten 1, 2, 3 zueinander und/oder des zumindest einen Bauelements 4 auf der ersten Leiterplatte 1 insbesondere im Kunststoffspritzgusswerkzeug zusätzlich zu verbessern, können zudem so genannte Supportgeometrien an einer oder mehrerer der Leiterplatten 1, 2, 3, insbesondere an der ersten und/oder zweiten Leiterplatte 1, 2, und/oder im Kunststoffspritzgusswerkzeug vorgesehen sein. D. h. entsprechende Stützungs- und/oder Halterungsausformungen.

Der auf die beschriebene Weise hergestellte Leiterplattenverbund V umfasst somit, wie in den Figuren 1 und 2 sowie 5 bis 7 gezeigt, zumindest die erste Leiterplatte 1 und die zweite Leiterplatte 2, welche auf die beschriebene Weise, insbesondere durch Zweinutsteckung, zumindest formschlüssig verbunden sind, beispielsweise zudem auch kraftschlüssig. Zweckmäßigerweise umfasst der auf die beschriebene Weise hergestellte Leiterplattenverbund V die erste, zweite und dritte Leiterplatte 1, 2, 3, wobei zumindest die erste Leiterplatte 1 und die zweite Leiterplatte 2 auf die beschriebene Weise, insbesondere durch Zweinutsteckung, zumindest formschlüssig, beispielsweise zudem auch kraftschlüssig, verbunden sind.

Die erste und/oder zweite Leiterplatte 1, 2 sind mit der dritten Leiterplatte 3 beispielsweise formschlüssig, kraftschlüssig und/oder stoffschlüssig verbunden, stoffschlüssig insbesondere durch den Kunststoff, insbesondere Duroplastkunststoff, aufgrund des oben beschriebenen Kunststoffumspritzens, und/oder beispielsweise durch Verlöten. Die formschlüssige Verbindung der ersten und/oder zweiten Leiterplatte 1, 2 mit der dritten Leiterplatte 3 wird beispielsweise durch einen oder mehrere in jeweilige Ausnehmungen der dritten Leiterplatte 3 eingeführte Positionierausformungen 5 erreicht. Der Formschluss zwischen erster und zweiter Leiterplatte 1, 2 kann zudem aus der oben beschriebenen Verrastung resultieren.

Der Leiterplattenverbund V kann beispielsweise in einem Getriebesteuergerät für ein Fahrzeug oder in einem anderen Steuergerät oder in einem anderen elektrischen Gerät verwendet werden. Insbesondere bei einer Verwendung im Getriebesteuergerät ist die erste Leiterplatte 1 zweckmäßigerweise als eine Sensorträgerleiterplatte ausgebildet und trägt als Bauelement 4 den Sensor. Die zweite Leiterplatte 2 ist als Stützleiterplatte und die dritte Leiterplatte 3 als Hauptleiterplatte ausgebildet. Durch die Anordnung der durch die zweite Leiterplatte 2 gestützten ersten Leiterplatte 1 auf der dritten Leiterplatte 3 ist ein so genannter Sensordom ausgebildet.

### Bezugszeichenliste

- 1: erste Leiterplatte
- 2: zweite Leiterplatte
- 2.1: breiter Bereich
- 2.2: schmaler Bereich
- 3: dritte Leiterplatte
- 4: Bauelement
- 5: Positionierausformung
- 6: Bauelementausnehmung
- 7: Rastnase
- 8: Leiterplattenrastnase

- B1, B2: Breitenausdehnung
- D1, D2: Dickenausdehnung
- L1, L2: Längenausdehnung
- N1, N2: Nut
- V: Leiterplattenverbund

## Patentansprüche

1. Verfahren zur Herstellung eines Leiterplattenverbundes (V), wobei eine erste Leiterplatte (1), insbesondere eine Sensorträgerleiterplatte, mit einer zweiten Leiterplatte (2), insbesondere einer Stützleiterplatte, formschlüssig verbunden wird, wobei die Längenausdehnungen (L1, L2) der beiden Leiterplatten (1, 2) parallel zueinander ausgerichtet sind, wobei beide Leiterplatten (1, 2) jeweils eine Nut (N1, N2) aufweisen und wobei die beiden Leiterplatten (1, 2) derart miteinander verbunden werden, dass sich Nutböden der beiden Nuten (N1, N2) berühren, wobei die beiden Leiterplatten (1, 2) derart zueinander ausgerichtet verbunden werden, dass Flächennormalen der beiden Leiterplatten (1, 2) rechtwinklig zueinander ausgerichtet sind,
**dadurch gekennzeichnet, dass**
die Nut (N1) im Bereich der von einem auf der ersten Leiterplatte (1) angeordneten Bauelement (4) abgewandten Querseite ausgebildet ist,
die zweite Leiterplatte (2) einen breiten Bereich (2.1) und einen anschließenden schmalen Bereich (2.2) aufweist, wobei der schmale Bereich (2.2) über einen wesentlichen Teil der Längenausdehnung (L1) der ersten Leiterplatte (1) liegt, und die Nut (N2)in der zweiten Leiterplatte (2) in einer Randseite des breiten Bereichs (2.1) ausgebildet ist, und dass
die Leiterplatten (1, 2) derart miteinander verbunden werden, dass das auf der ersten Leiterplatte (1) angeordnete Bauelement (4), insbesondere Sensor, durch die zweite Leiterplatte (2) in seiner Position gestützt wird.

2. Verfahren nach Anspruch 1,
wobei die beiden Leiterplatten (1, 2) miteinander verrastet werden.

3. Verfahren nach einem der vorhergehenden Ansprüche,
wobei zumindest die erste Leiterplatte (1) mit einer dritten Leiterplatte (3) verbunden wird.

4. Verfahren nach einem der vorhergehenden Ansprüche,
wobei zumindest eine Positionierausformung (5) der ersten Leiterplatte (1) in eine korrespondierende Ausnehmung in der dritten Leiterplatte (3) eingeführt wird und/oder die erste Leiterplatte (1) und die dritte Leiterplatte (3) miteinander verlötet werden.

5. Verfahren nach einem der vorhergehenden Ansprüche,
wobei zumindest die erste Leiterplatte (1) mit einem Kunststoff zumindest bereichsweise umspritzt wird.

6. Leiterplattenverbund (V), insbesondere hergestellt mittels eines Verfahrens nach einem der vorhergehenden Ansprüche, umfassend mindestens zwei formschlüssig miteinander verbundene Leiterplatten (1, 2), wobei eine erste Leiterplatte (1), insbesondere eine Sensorträgerleiterplatte, mit einer zweiten Leiterplatte (2), insbesondere einer Stützleiterplatte, formschlüssig verbunden ist, wobei die Längenausdehnungen (L1, L2) der beiden Leiterplatten (1, 2) parallel zueinander ausgerichtet sind, wobei beide Leiterplatten (1, 2) jeweils eine Nut (N1, N2) aufweisen und wobei die beiden Leiterplatten (1, 2) derart miteinander verbunden sind, dass sich Nutböden der beiden Nuten (N1, N2) berühren, wobei die beiden Leiterplatten (1, 2) derart zueinander ausgerichtet verbunden sind, dass Flächennormalen der beiden Leiterplatten (1, 2) rechtwinklig zueinander ausgerichtet sind,
**dadurch gekennzeichnet, dass** die Nut (N1) im Bereich der von einem auf der ersten Leiterplatte (1) angeordneten Bauelement (4) abgewandten Querseite ausgebildet ist, die zweite Leiterplatte (2) einen breiten Bereich (2.1) und einen anschließenden schmalen Bereich (2.2) aufweist, wobei der schmale Bereich (2.2) über einen wesentlichen Teil der Längenausdehnung (L1) der ersten Leiterplatte (1) liegt, und die Nut (N2) in der zweiten Leiterplatte (2) in einer Randseite des breiten Bereichs (2.1) ausgebildet ist, und dass die Leiterplatten (1, 2) derart miteinander verbunden sind, dass das auf der ersten Leiterplatte (1) angeordnete Bauelement (4), insbesondere Sensor, durch die zweite Leiterplatte (2) in seiner Position gestützt ist.

7. Leiterplattenverbund (V) nach Anspruch 6, umfassend drei miteinander verbundene Leiterplatten (1, 2, 3).

## Claims

1. A method for manufacturing a printed circuit board assembly (V), wherein a first printed circuit board (1), in particular a sensor-carrying printed circuit board, is form-fittingly connected to a second printed circuit board (2), in particular a supporting printed circuit board, wherein the longitudinal extensions (L1, L2) of the two printed circuit boards (1, 2) are aligned in parallel to each other, wherein
both printed circuit boards (1, 2) each have a groove (N1, N2) and wherein the two printed circuit boards (1, 2) are connected with each other such that groove bases of the two grooves (N1, N2) contact each other, wherein the two printed circuit boards (1, 2) are connected in alignment with each other such that the surface normals of the two printed circuit boards (1, 2) are aligned at right angles relative to each other,
**characterized in that**
the groove (N1) is formed in the region of the transverse side facing away from a component (4) arranged on the first printed circuit board (1),
the second printed circuit board (2) has a wide region (2.1) and an adjoining narrow region (2.2), wherein the narrow region (2.2) is located over a substantial part of the longitudinal extension (L1) of the first printed circuit board (1) and the groove (N2) is formed in the second printed circuit board (2) in an edge side of the wide region (2.1), and **in that**
the printed circuit boards (1, 2) are connected with each other such that the component (4), in particular a sensor, arranged on the first printed circuit board (1) is supported in its position by the second printed circuit board (2).

2. The method according to Claim 1,
wherein the two printed circuit boards (1, 2) are interlocked with each other.

3. The method according to either one of the preceding claims,
wherein at least the first printed circuit board (1) is connected to a third printed circuit board (3).

4. The method according to any one of the preceding claims,
wherein at least one positioning projection (5) of the first printed circuit board (1) is inserted into a corresponding recess in the third printed circuit board (3) and/or the first printed circuit board (1) and the third printed circuit board (3) are soldered to each other.

5. The method according to any one of the preceding claims,
wherein at least the first printed circuit board (1) is overmolded with a plastic at least in regions.

6. A printed circuit board assembly (V), in particular manufactured by means of a method according to any one of the preceding claims, comprising at least two printed circuit boards (1, 2) connected form-fittingly to each other, wherein a first printed circuit board (1), in particular a sensor-carrying printed circuit board, is form-fittingly connected to a second printed circuit board (2), in particular a supporting printed circuit board, wherein the longitudinal extensions (L1, L2) of the two printed circuit boards (1, 2) are aligned in parallel to each other, wherein
both printed circuit boards (1, 2) each have a groove (N1, N2) and wherein the two printed circuit boards (1, 2) are connected with each other such that groove bases of the two grooves (N1, N2) contact each other, wherein the two printed circuit boards (1, 2) are connected in alignment with each other such that the surface normals of the two printed circuit boards (1, 2) are aligned at right angles relative to each other,
**characterized in that**
the groove (N1) is formed in the region of the transverse side facing away from a component (4) arranged on the first printed circuit board (1), the second printed circuit board (2) has a wide region (2.1) and an adjoining narrow region (2.2), wherein the narrow region (2.2) is located over a substantial part of the longitudinal extension (L1) of the first printed circuit board (1) and the groove (N2) is formed in the second printed circuit board (2) in an edge side of the wide region (2.1), and **in that** the printed circuit boards (1, 2) are connected with each other such that the component (4), in particular a sensor, arranged on the first printed circuit board (1) is supported in its position by the second printed circuit board (2).

7. The printed circuit board assembly (V) according to Claim 6, comprising three printed circuit boards (1, 2, 3) connected to each other.

## Revendications

1. Procédé de fabrication d'un assemblage de cartes de circuits imprimés (V), une première carte de circuits imprimés (1), notamment une carte de circuits imprimés porte-capteur, étant reliée par complémentarité de formes à une deuxième carte de circuits imprimés (2), notamment une carte de circuits imprimés de soutien, les extensions longitudinales (L1, L2) des deux cartes de circuits imprimés (1, 2) étant orientées parallèlement l'une à l'autre, les deux cartes de circuits imprimés (1, 2) présentant chacune une rainure (N1, N2) et les deux cartes de circuits imprimés (1, 2) étant reliées l'une à l'autre de telle sorte que les fonds de rainure des deux rainures (N1, N2) se touchent, les deux cartes de circuits imprimés (1, 2) étant reliées en étant orientées l'une par rapport à l'autre de telle sorte que les normales aux surfaces des deux cartes de circuits imprimés (1, 2) sont orientées à angle droit l'une de l'autre,
**caractérisé en ce que**
la rainure (N1) est formée dans la zone du côté transversal détourné d'un composant (4) agencé sur la première carte de circuits imprimés (1),
la deuxième carte de circuits imprimés (2) présente une zone large (2.1) et une zone étroite (2.2) qui s'y raccorde, la zone étroite (2.2) étant située sur une partie essentielle de l'extension longitudinale (L1) de la première carte de circuits imprimés (1), et la rainure (N2) dans la deuxième carte de circuits imprimés (2) étant formée dans un côté de bord de la zone large (2.1), et **en ce que**
les cartes de circuits imprimés (1, 2) sont reliées entre elles de telle sorte que le composant (4), notamment le capteur, agencé sur la première carte de circuits imprimés (1) est soutenu dans sa position par la deuxième carte de circuits imprimés (2).

2. Procédé selon la revendication 1,
dans lequel les deux cartes de circuits imprimés (1, 2) sont encliquetées l'une avec l'autre.

3. Procédé selon l'une quelconque des revendications précédentes,
dans lequel au moins la première carte de circuits imprimés (1) est reliée à une troisième carte de circuits imprimés (3).

4. Procédé selon l'une quelconque des revendications précédentes,
dans lequel au moins une formation de positionnement (5) de la première carte de circuits imprimés (1) est insérée dans un évidement correspondant de la troisième carte de circuits imprimés (3) et/ou la première carte de circuits imprimés (1) et la troisième carte de circuits imprimés (3) sont soudées ensemble.

5. Procédé selon l'une quelconque des revendications précédentes,
dans lequel au moins la première carte de circuits imprimés (1) est surmoulée avec une matière plastique au moins par zones.

6. Assemblage de cartes de circuits imprimés (V), notamment fabriqué au moyen d'un procédé selon l'une quelconque des revendications précédentes, comprenant au moins deux cartes de circuits imprimés (1, 2) reliées entre elles par complémentarité de forme, une première carte de circuits imprimés (1), notamment une carte de circuits imprimés porte-capteur, étant reliée par complémentarité de formes à une deuxième carte de circuits imprimés (2), notamment une carte de circuits imprimés de soutien, les extensions longitudinales (L1, L2) des deux cartes de circuits imprimés (1, 2) étant orientées parallèlement l'une à l'autre, les deux cartes de circuits imprimés (1, 2) présentant chacune une rainure (N1, N2) et les deux cartes de circuits imprimés (1, 2) étant reliées l'une à l'autre de telle sorte que les fonds de rainure des deux rainures (N1, N2) se touchent, les deux cartes de circuits imprimés (1, 2) étant reliées en étant orientées l'une par rapport à l'autre de telle sorte que les normales aux surfaces des deux cartes de circuits imprimés (1, 2) sont orientées à angle droit l'une de l'autre,
**caractérisé en ce que**
la rainure (N1) est formée dans la zone du côté transversal détourné d'un composant (4) agencé sur la première carte de circuits imprimés (1), la deuxième carte de circuits imprimés (2) présente une zone large (2.1) et une zone étroite (2.2) qui s'y raccorde, la zone étroite (2.2) étant située sur une partie essentielle de l'extension longitudinale (L1) de la première carte de circuits imprimés (1), et la rainure (N2) dans la deuxième carte de circuits imprimés (2) étant formée dans un côté de bord de la zone large (2.1), et **en ce que** les cartes de circuits imprimés (1, 2) sont reliées entre elles de telle sorte que le composant (4), notamment le capteur, agencé sur la première carte de circuits imprimés (1) est soutenu dans sa position par la deuxième carte de circuits imprimés (2).

7. Assemblage de cartes de circuits imprimés (V) selon la revendication 6, comprenant trois cartes de circuits imprimés (1, 2, 3) reliées entre elles.
